# EUROPÄISCHE PATENTSCHRIFT

(11) **EP 1 906 497 B1**
(45) Veröffentlichungstag und Bekanntmachung des Hinweises auf die Patenterteilung: **05.01.2011**
(21) Anmeldenummer: 07016842.2
(22) Anmeldetag: 28.08.2007
(51) Int. Cl.: H01S 5/183, H01S 5/36, H01S 3/0941

(54) **Halbleiterlaservorrichtung und Verfahren zu deren Herstellung**
Semi-conductor laser device and method for its manufacture
Dispositif laser à semi-conducteur et son procédé de fabrication

(30) Priorität: 27.09.2006 DE 102006045706; 16.01.2007 DE 102007002303
(43) Veröffentlichungstag der Anmeldung: 02.04.2008
(73) Patentinhaber: OSRAM Opto Semiconductors GmbH, 93055 Regensburg (DE)
(72) Erfinder: Philippens, Marc, Dr., 93049 Regensburg (DE)
(74) Vertreter: Epping - Hermann - Fischer

(56) Entgegenhaltungen:
- EP-A- 0 795 941
- EP-A- 1 220 392
- EP-A- 1 411 607
- EP-A1- 1 641 092
- WO-A-01/93386
- WO-A-03/094311
- DE-A1- 10 223 540
- JP-A- 2001 189 527
- US-A- 5 796 771
- US-B1- 6 330 262
- US-B2- 6 876 684

## Beschreibung

Diese Patentanmeldung beansprucht die Prioritäten der deutschen Patentanmeldungen Nr. 10 2006 045 706.4 vom 27. September 2006 und Nr. 10 2007 002 303.2 vom 16. Januar 2007.

Die Erfindung betrifft eine Halbleiterlaservorrichtung mit mindestens einem optisch gepumpten oberflächenemittierenden Vertikalemitter und mindestens einer monolithisch integrierten Pumpstrahlungsquelle zum optischen Pumpen des Vertikalemitters und ein Verfahren zu deren Herstellung.

Mit optisch gepumpten vertikal emittierenden Halbleiterlaservorrichtungen lassen sich hohe Ausgangsleistungen bei gleichzeitig guter Strahlqualität verwirklichen. Durch monolithisch auf einem Substrat integrierte Pumpstrahlungsquellen kann ein kompakter Aufbau erreicht werden.

Seitlich gepumpte anorganische Vertikalemitter und Vertikal gepumpte Vertikalemitter mit organischer aktiver Schicht sind aus WO 01/93 386 A1 und US 6,876, 684 B2 bekannt.

Der Erfindung liegt die Aufgabe zugrunde, eine Halbleiterlaservorrichtung der eingangs genannten Art zu schaffen, die flexibel bezüglich der Wellenlänge der von ihr erzeugten Laserstrahlung herstellbar ist. Weiterhin soll ein vorteilhaftes Verfahren zu deren Herstellung angegeben werden.

Diese Aufgabe wird durch eine Halbleiterlaservorrichtung gemäß Patentanspruch 1 und ein Verfahren nach Patentanspruch 23 gelöst. Vorteilhafte Ausgestaltungen sind Gegenstand der jeweiligen abhängigen Ansprüche.

Gemäß einem ersten Aspekt der Erfindung weist die Halbleiterlaservorrichtung mindestens einen optisch gepumpten, oberflächenemittierenden Vertikalemitter mit mindestens einer strahlungserzeugenden Vertikalemitterzone auf. Weiter weist sie mindestens eine monolithisch integrierte Pumpstrahlungsquelle zum optischen Pumpen des Vertikalemitters auf, wobei die mindestens eine Pumpstrahlungsquelle zur Emission von Pumpstrahlung in einer Hauptstrahlungsrichtung eingerichtet ist, die quer zu einer Hauptstrahlungsrichtung einer Vertikalstrahlung des mindestens einen Vertikalemitters verläuft. Die Halbleiterlaservorrichtung zeichnet sich dadurch aus dass die mindestens eine Vertikalemitterzone (5) des Vertikalemitters (1) mindestens eine Schicht aufweist, die strahlungserzeugendes organisches Material enthält.

Die Gruppe organischer Materialien umfasst eine Vielzahl von organischen Substanzen, die sich durch eine große Bandbreite unterschiedlicher optischer und elektrischer Eigenschaften, zum Beispiel ihrer energetischen Bandlücke, auszeichnen. Durch Auswahl geeigneter Substanzen für mindestens eine Schicht des Vertikalemitters können die optischen Eigenschaften des Vertikalemitters, zum Beispiel die Wellenlänge der Vertikalstrahlung, in weiten Grenzen gewünschten Anforderungen angepasst werden. Verglichen mit anorganischen Halbleitermaterialien lassen sich organische Materialien zudem in relativ einfachen Verfahren, zum Beispiel durch thermisches Verdampfen oder Aufschleudern in gelöster Form, auf Substrate aufbringen.

In einer vorteilhaften Ausgestaltung der Halbleiterlaservorrichtung ist das organische Material strahlungserzeugend und in der mindestens einen Vertikalemitterzone enthalten. Insbesondere auf diese Weise lassen sich die optischen Eigenschaften des Vertikalemitters in weiten Grenzen durch die Auswahl eines geeigneten organischen Materials variieren.

In einer weiteren vorteilhaften Ausgestaltung der Halbleiterlaservorrichtung ist das organische Material halbleitend. Auf diese Weise können stromführende oder ladungsträgerinjizierende Schichten als organische Schichten ausgeführt werden und mithilfe der oben genannten relativ einfachen Verfahren aufgebracht werden.

In einer weiteren vorteilhaften Ausgestaltung der Halbleiterlaservorrichtung ist der Vertikalemitterzone in vertikaler Richtung ein interner Resonatorspiegel, insbesondere ein Bragg-Reflektor, nachgeordnet. Die Vertikalstrahlung kann dabei entweder auf einer einem Substrat gegenüberliegenden Seite ausgekoppelt werden, falls der interne Resonatorspiegel zwischen der mindestens einen Vertikalemitterzone und dem Substrat angeordnet ist und die Vertikalstrahlung, oder durch das Substrat, falls der interne Resonatorspiegel dem Substrat und der mindestens einen Vertikalemitterzone nachgeordnet ist. Im letzten Fall kann zur Auskopplung der von der mindestens einen Vertikalemitterzone erzeugten Vertikalstrahlung ein Auskoppelfenster vorgesehen ein.

Gemäß weiterer vorteilhafter Ausgestaltungen der Halbleiterlaservorrichtung ist der mindestens einen Vertikalemitterzone ein externer Spiegel zugeordnet, der zusammen mit dem internen Resonatorspiegel einen Resonator für den Vertikalemitter bildet, oder es ist ein weiterer interner Resonatorspiegel vorgesehen, wobei der weitere interne Resonatorspiegel und der interne Resonatorspiegel die Vertikalemitterzone in vertikaler Richtung umschließen und so einen Resonator für die Vertikalstrahlung bilden und wobei der weitere interne Resonatorspiegel teildurchlässig ist und der Auskopplung der Vertikalstrahlung dient. Im Fall des internen Resonators kann ein kompakter Aufbau ermöglicht werden. Im Fall des externen Resonators kann eine hohe Resonatorgüte und eine entsprechend enge spektrale Breite der Vertikalstrahlung erreicht werden.

In einer weiteren vorteilhaften Ausgestaltung der Halbleiterlaservorrichtung ist die mindestens eine Pumpstrahlungsquelle ein kantenemittierender Laser ist. Bevorzugt sind mindestens zwei Pumpstrahlungsquellen auf einander gegenüberliegenden Seiten des mindestens einen Vertikalemitters angeordnet, wobei die mindestens zwei Pumpstrahlungsquellen einen gemeinsamen Resonator aufweisen und zusammen einen Laser bilden.

In weiteren vorteilhaften Ausgestaltungen der Halbleiterlaservorrichtung weist die mindestens eine Pumpstrahlungsquelle eine aktive, strahlungserzeugende Pumpschicht, die in vertikaler Richtung entweder zumindest teilweise mit der aktiven Vertikalemitterzone überlappend angeordnet ist, oder die in vertikaler Richtung der aktiven Vertikalemitterzone nachgeordnet ist.

In weiteren vorteilhaften Ausgestaltungen der Halbleiterlaservorrichtung weist die mindestens eine Pumpstrahlungsquelle eine Schichtfolge auf Basis eines III-V oder eines II-VI Verbindungshalbleiters auf oder sie weist eine Schicht auf, die ein halbleitendes organisches Material enthält. Im letzteren Fall kann das halbleitende organische Material der Pumpstrahlungsquelle ein Polymer oder eine niedermolekulare organische Verbindung sein. Ebenfalls bevorzugt ist, als halbleitendes organisches Material der mindestens einen Schicht des Vertikalemitters ein Polymer einzusetzen. Weiter ist bevorzugt, dass das halbleitende organisches Material niedermolekulare organisches Verbindungen aufweist. Polymerschichten lassen sich vorteilhaft auch großflächig, beispielsweise durch Aufschleudern in gelöster Form, einfach herstellen.

In einer weiteren vorteilhaften Ausgestaltung der Halbleiterlaservorrichtung ist die Wellenlänge der Pumpstrahlung kleiner als die Wellenlänge der Vertikalstrahlung. Auf diese Weise wird effektives optisches Pumpen ermöglicht.

In einer weiteren vorteilhaften Ausgestaltung der Halbleiterlaservorrichtung sind mindestens zwei Vertikalemitter mit unterschiedlichen Wellenlängen ihrer Vertikalstrahlung vorgesehen. Besonders bevorzugt ist eine Mehrzahl von Vertikalemittern in einer regelmäßigen Anordnung vorgesehen. Auf diese Weise lassen sich vorteilhaft Anzeigeeinheiten und wie Flächenstrahler wirkende Einheiten realisieren.

Gemäß einem zweiten Aspekt der Erfindung umfasst ein Verfahren zur Herstellung einer Halbleiterlaservorrichtung der zuvor beschriebenen Art die folgenden Schritte: Es wird ein Substrat bereitgestellt, auf das eine Halbleiterschichtenfolge aufgebracht wird, wobei die Halbleiterschichtenfolge eine strahlungserzeugende Schicht aufweist und geeignet ist, eine Pumpstrahlungsquelle zu bilden. Weiter wird eine Ausnehmung in der Halbleiterschichtenfolge gebildet, in die eine Schichtenfolge aufgebracht wird, wobei die Schichtenfolge mindestens eine strahlungserzeugende Schicht aufweist und mindestens eine Schicht aufweist, die ein organisches Material enthält, und wobei die Schichtenfolge geeignet ist, einen Vertikalemitter zu bilden.

In einer vorteilhaften Ausgestaltung des Verfahrens zur Herstellung einer Halbleiterlaservorrichtung enthält die mindestens eine strahlungserzeugende Schicht, die in die Ausnehmung in der Halbleiterschichtenfolge aufgebracht wird, das organische Material.

In weiteren vorteilhaften Ausgestaltung des Verfahrens umfasst der Schritt des Herstellen der mindestens einen Ausnehmung einen Ätzschritt oder wird durch eine Maskierung des Substrats während des Aufbringens der Halbleiterschichtenfolge realisiert.

### Im Folgenden wird die Erfindung anhand von

Ausführungsbeispielen mit Hilfe von vier Figuren näher erläutert. Die Figuren zeigen:
- Figur 1: eine schematische Schnittdarstellung eines ersten Ausführungsbeispiels einer Halbleiterlaservorrichtung,
- Figur 2: eine schematische Draufsicht auf ein zweites Ausführungsbeispiel einer Halbleiterlaservorrichtung,
- Figur 3: eine schematische Schnittdarstellung eines dritten Ausführungsbeispiels einer Halbleiterlaservorrichtung und
- Figur 4: eine schematische Draufsicht auf ein viertes Ausführungsbeispiel einer Halbleiterlaservorrichtung.

Die Figuren sind schematische Zeichnungen. Insbesondere sind die Größenverhältnisse der Elemente und die Schichtdicken nicht maßstabsgerecht dargestellt.

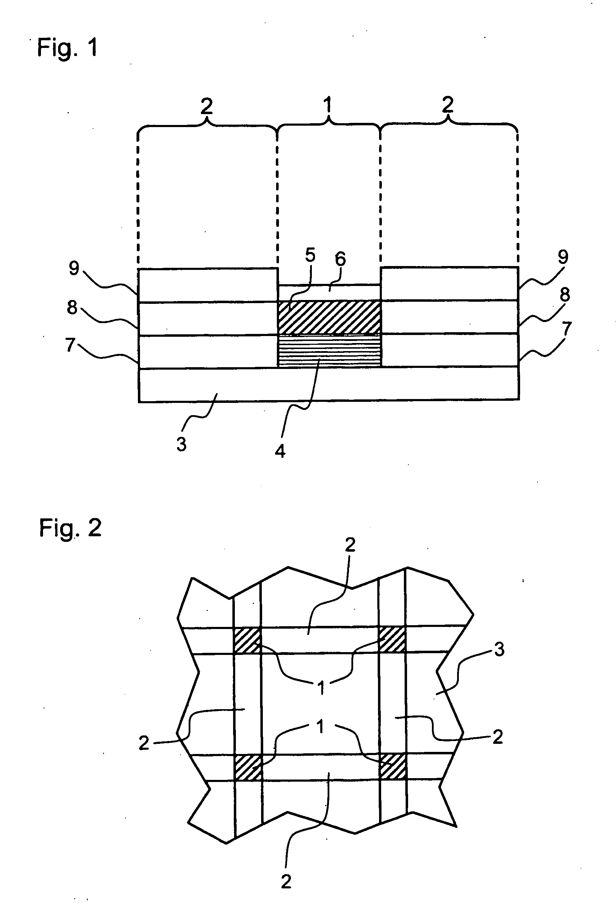

Das in Figur 1 schematisch in einer Schnittzeichnung dargestellte Ausführungsbeispiel einer Halbleiterlaservorrichtung weist einen zentral angeordneten Vertikalemitter 1 und zwei auf gegenüberliegenden Seiten des Vertikalemitters angeordnete Pumpstrahlungsquellen 2 auf. Der Vertikalemitter 1 und die Pumpstrahlungsquellen 2 sind auf einem gemeinsamen Substrat 3 aufgewachsen. Im Bereich des Vertikalemitters 1 ist auf das Substrat 3 ein Bragg-Reflektor 4 aufgebracht. Auf diesem ist eine aktive Vertikalemitterzone 5 angeordnet, auf die eine Deckschicht 6 aufgebracht ist. Im Bereich der Pumpstrahlungsquellen 2 ist auf dem Substrat 3 jeweils eine p-seitige Schichtenfolge 7 angeordnet, gefolgt von einer aktiven Pumpstrahlungsschicht 8 sowie einer n-seitigen Schichtenfolge 9.

Das Ausführungsbeispiel in Figur 1 zeigt eine Halbleiterlaservorrichtung, bei der ein organischer Vertikalemitter 1 von anorganischen Pumpstrahlungsquellen 2 gepumpt wird. Die Klassifizierung des Vertikalemitter 1 als organisch besagt dabei, dass zumindest eine der Schichten des Vertikalemitters 1 organisches Material enthält. Insbesondere ist dieses eine optisch aktive Schicht in der Vertikalemitterzone 5. Die Klassifizierung der Pumpstrahlungsquellen 2 als anorganisch besagt umgekehrt, dass die Pumpstrahlungsquellen 2 im Wesentlichen anorganische Schichten aufweisen. Die Pumpstrahlungsquellen 2 können beispielsweise auf der Basis eines III-V Verbindungshalbleiter-Materialsystem realisiert werden und Schichten einer Zusammensetzung wie InₓAl_{y}Ga_{1-x-y}N, InₓAlyGa_{1-x-y}As, InₓAl_{y}Ga_{1-x-y}P oder InₓGa₁₋ₓAs_{y}N_{1-y} mit 0≤x≤1, 0≤y≤1, 0≤x+y≤1 aufweisen. Selbstverständlich sind die Pumpstrahlungsquellen nicht auf dieses Materialsystem beschränkt, sondern können je nach Wellenlänge oder sonstiger Anforderungen auch auf der Basis anderer Halbleitermaterialsysteme, zum Beispiel auf Basis eines II-VI Verbindungshalbleiter-Materialsystems, realisiert werden.

Die Pumpstrahlungsquellen 2 sind in dem gezeigten Beispiel als kantenemittierende Pumplaser ausgeführt, derer laseraktives Medium die aktive Pumpschicht 8 darstellt. Die äußeren Seitenflächen der Pumpstrahlungsschicht 8 sind verspiegelt ausgeführt, sodass die beiden Pumpstrahlungsschichten 8 der Pumpstrahlungsquellen 2 zusammen mit der Vertikalemitterzone 5 gemeinsam einen Resonator für Pumpstrahlung bilden. Die Verspiegelung der Enden der Pumpstrahlungsschicht 8 kann entweder durch Aufdampfen einer hoch reflektiven Metallschicht erfolgen. An Stelle oder in Kombination mit einer Verspiegelung kann der Resonator für die Pumpstrahlung auch durch eine Strukturierung der Pumpstrahlungsschicht 8 gebildet werden, wenn durch die Strukturierung Totalreflexion an einer inneren Grenzschicht der Pumpstrahlungsschicht 8 erreicht wird. Eine solche Strukturierung besteht zum Beispiel in der Ausformung der Enden der Pumpstrahlungsschicht als prismenförmiger Retro-Reflektor.

Die p-seitige Schichtenfolge 7 und die n-seitige Schichtenfolge 9 umfassen die Pumpstrahlungsschicht 8 in vertikaler Richtung und dienen sowohl der Zufuhr von Ladungsträgern, die in der Pumpstrahlungsschicht 8 strahlend rekombinieren, als auch der Wellenführung der im Betrieb entstehenden Pumpstrahlung. Um einen effektiven Pumpprozess zu ermöglichen sollte bei diesem, wie auch bei den im Folgenden gezeigten Ausführungsbeispielen die Wellenlänge der Pumpstrahlung kleiner sein als die Wellenlänge der vom Vertikalemitter 1 erzeugten Vertikalstrahlung.

Die p-seitige Schichtenfolge 7 beziehungsweise die n-seitige Schichtenfolge 9 können Kontaktschichten, Mantelschichten, Wellenleiterschichten und Barriereschichten umfassen. Das Substrat 3, beispielsweise ein GaN-Substrat, ist vorteilhafterweise wie die p-seitige Schichtenfolge 7 p-dotiert. Selbstverständlich kann die Reihenfolge der p-beziehungsweise n-seitigen Schichtenfolge 7 und 9 getauscht sein und ein n-dotiertes Substrat 3 eingesetzt werden. Auf der jeweils von der aktiven Pumpstrahlungsschicht 8 abgewandten Seite der n-seitigen Schichtenfolge 9 und des Substrats 3 ist eine hier nicht gezeigte Kontaktmetallisierung zur Ladungsträgerinjektion in die Pumpstrahlungsquellen 2 vorgesehen.

Im Bereich des Vertikalemitters 1 ist auf das Substrat 3 der Bragg-Reflektor 4 aufgebracht, eine Schichtenfolge, die alternierend gestapelte dielektrische Schichten mit unterschiedlichem Brechungsindex aufweist. Als Materialien kommen hier zum Beispiel TiO₂ und SiO₂ in Frage. Der Bragg-Reflektor 4 ist so ausgelegt, dass er für von dem Vertikalemitter 1 im Betrieb emittierte Vertikalstrahlung reflektierend ist.

Auf dem Bragg-Reflektor 4 ist die aktive Vertikalemitterzone 5 angeordnet. Im gezeigten Beispiel umfasst die Vertikalemitterzone 5 strahlungserzeugendes organischem Material, zum Beispiel ein organisches Material mit geringem Molekulargewicht, auch niedermolekulare Verbindung oder kleinmoleküliges organisches Material genannt, ein Polymer oder eine Kombination dieser beiden Materialien.

Kleinmolekülige organische Materialien (small molecule material) werden typischerweise durch thermisches Verdampfen unter Vakuumbedingungen aufgebracht. Beispiele für strahlungserzeugende kleinmolekülige organische Materialien sind Tris(8-hydroxychinolinato)aluminium (Alq), 1,3-Bis(N,N-dimethylaminophenyl)-1,3,4-oxidazol (OXD-8), Oxo-bis(2-methyl-8-chinolinato)aluminium, Bis(2-methyl-8-hydroxychinolinato)aluminium; Bis(hydroxybenzochinolinato)beryllium (BeQ.sub.2), Bis(diphenylvinyl)biphenylen (DPVBI) und Arylaminsubstituiertes Distyrylarylen (DSA-Amin).

Polymere werden üblicherweise durch ein Aufschleuderverfahren, auch Spincasting oder Spincoating genannt, aufgetragen. Alternativ kann auch ein räumlich selektives Abscheiden erfolgen, z.B. durch Tintenstrahldrucken. Beispiele für strahlungserzeugende Polymere sind Poly(p-phenylenvinylen) und Polyarylenvinylen sowie Copolymere von Arylen-Vinylen-Oligomeren, Polyarylene, Polychinolin sowie jeweils deren Derivate und Mischungen.

Bevorzugt ist die Vertikalemitterzone 5 nicht als eine homogene Schicht ausgestaltet, sondern als eine Schichtenfolge aus alternierend aufgebrachten optisch aktiven und optisch inaktiven Schichten. Die optisch aktiven Schichten zeichnen sich dabei durch eine hohe Quanteneffizienz für eine strahlende Rekombination von Ladungsträgerpaaren aus. Die Ladungsträgerpaare werden im Betrieb der Halbleiterlaservorrichtung durch optisches Pumpen durch die seitlich in die Vertikalemitterzone 5 eingestrahlte Pumpstrahlung der Pumpstrahlungsquellen 2 in den optisch inaktiven und/oder den optisch aktiven Schichten der Vertikalemitterzone 5 gebildet.

Auf die Vertikalemitterzone 5 ist die Deckschicht 6 aufgebracht, die aus einem Material besteht, das möglichst transparent für die erzeugte Vertikalemitterstrahlung ist und die typischerweise hydrophile Vertikalemitterzone 5 vor eindringender Feuchtigkeit schützt.

Zum Betrieb der Halbleiterlaservorrichtung ist ein in der Figur nicht gezeigter externer teildurchlässiger Resonatorspiegel vorgesehen. Der externe Resonatorspiegel bildet zusammen mit dem internen Bragg-Reflektor 4 einen Resonator für den Vertikalemitter 1.

Die in Figur 1 gezeigte Halbleiterlaservorrichtung kann hergestellt werden, indem zunächst die Schichtenfolge der Pumpstrahlungsquellen 2 flächig in einem Epitaxieverfahren auf eine Halbleiterscheibe (Wafer) als Substrat 3 aufgebracht wird. Anschließend wird die entstandene Schichtfolge zum Beispiel durch einen Ätzvorgang strukturiert, sodass voneinander beabstandete, stabförmige Pumpstrahlungsquellen 2 mit dazwischen liegenden Öffnungen für die Vertikalemitter 1 gebildet werden. In einem anschließenden Schritt werden mit Hilfe einer Beschichtungsmaske zunächst die Bragg-Reflektoren 4 in die Öffnungen zwischen den Pumpstrahlungsquellen abgeschieden. Danach werden in einem nächsten Prozessschritt die Vertikalemitterzonen 5, zum Beispiel durch thermisches Verdampfen geeigneter organischer Substanzen, aufgebracht und mit der Deckschicht 6 abgedeckt. In einem abschließenden Schritt werden einzelne Halbleiterlaservorrichtungen, jeweils einen oder mehrere Vertikalemitter 1 und zugeordnete Pumpstrahlungsquellen 2 aufweisend, separiert und die Seitenflächen der Pumpstrahlungsquellen 2 zur Ausbildung von Resonatoren für die Pumpstrahlung verspiegelt bzw. strukturiert. Alternativ ist eine Verspiegelung bereits im Waferverbund möglich oder wegen des Einsatzes von Elementen wie Retro-Reflektoren, in denen Totalreflexion ausgenutzt wird, nicht erforderlich.

In Figur 2 ist ein Ausschnitt einer Draufsicht auf ein zweites Ausführungsbeispiel einer Halbleiterlaservorrichtung gezeigt. Bei dieser Halbleiterlaservorrichtung ist auf einem Substrat 3 eine Mehrzahl von Vertikalemittern 1 in einem regelmäßigen rechteckigen Muster angeordnet. Zwischen den Vertikalemittern 1 sind Pumpstrahlungsquellen 2 vorgesehen.

Beide Seiten jeder Pumpstrahlungsquelle 2 können dabei verspiegelt sein, wobei jeweils entweder eine oder beide der Endflächen teildurchlässig sein können und als Auskoppelspiegel dienen können. Jede Pumpstrahlungsquelle 2 stellt damit einen Laserresonator dar, der zum optischen Pumpen einer oder beider benachbarter Vertikalemitter 1 vorgesehen ist.

Die Halbleiterlaservorrichtung der Figur 2 wirkt durch ihre Mehrzahl von Vertikalemittern 1 bei entsprechend geringem Abstand der Vertikalemitter 1 voneinander wie ein Flächenstrahler. Wenn die Pumpstrahlungsquellen 2 elektrisch getrennt ansteuerbar sind, kann die Halbleiterlaservorrichtung zu Anzeigenzwecken eingesetzt werden. Eine mehrfarbige Darstellung ist möglich, wenn Vertikalemitter 1 in unterschiedlicher Farbe, zum Beispiel in den drei Grundfarben rot, grün, blau, eingesetzt werden. In einem solchen Fall bietet sich insbesondere eine Anordnung der Vertikalemitter 1 in einem hexagonalen Muster an.

Resonatoren für die Vertikalstrahlung können dabei durch einen parallel zum Substrat 3 angeordneten, ebenfalls flächigen und teildurchlässigen externen Resonatorspiegel gebildet werden. Alternativ ist möglich, für jeden Vertikalemitter 1 einen weiteren internen Resonatorspiegel vorzusehen, der ähnlich dem Bragg-Reflektor 4 ausgeführt sein kann.

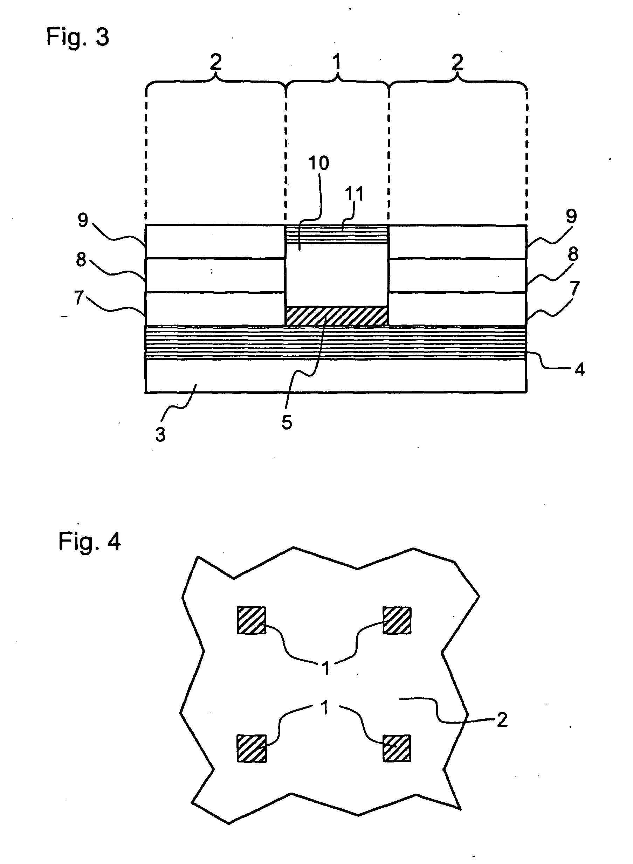

In Figur 3 ist ein weiteres Ausführungsbeispiel einer Halbleiterlaservorrichtung in einem Schnittbild analog zu Figur 1 dargestellt. Gleiche Bezugszeichen bezeichnen dabei gleiche oder gleich wirkende Elemente.

Das Ausführungsbeispiel in Figur 3 zeigt eine Halbleiterlaservorrichtung, bei der ein organischer Vertikalemitter 1 von organischen Pumpstrahlungsquellen 2 gepumpt wird. Sowohl Vertikalemitter 1 als auch Pumpstrahlungsquellen 2 enthalten somit zumindest in der jeweiligen optisch aktiven Schicht, der Vertikalemitterzone 5 beziehungsweise der Pumpschicht 8, organisches Material. In einem solchen Fall ist es vorteilhaft, den anorganischen Bragg-Reflektor 4 in einem ersten Prozessierungsschritt flächig auf das Substrat 3 aufzubringen. Anschließend werden die Pumpstrahlungsquellen 2, umfassend die p-seitige Schichtenfolge 7, die Pumpstrahlungsschicht 8 und die n-seitige Schichtenfolge 9, aufgebracht. Beim Aufbringen der Pumpstrahlungsquellen 2 werden Maskierungstechniken derart eingesetzt, dass Bereiche für die anschließend aufzubringenden Vertikalemitter 1 frei bleiben, wobei selbstverständlich das Aufbringen von Pumpstrahlungsquellen 2 und Vertikalemitter 1 auch in umgekehrter Reihenfolge erfolgen kann.

Da die Schichten des Bragg-Reflektors 4 üblicherweise dielektrische, nicht leitende Schichten sind, ist eine Stromeinprägung in die Pumpstrahlungsquellen 2 durch das Substrat im Gegensatz zum Ausführungsbeispiel von Figur 1 in diesem Fall nicht möglich. Durch das Vorsehen von Gräben bis auf die Tiefe einer Strom führenden Schicht innerhalb der p-seitigen Schichtenfolge 7 und Aufbringen einer Kontaktfläche in diesem Bereich kann jedoch eine seitliche Stromzufuhr in die p-seitige Schichtenfolge 7 erfolgen. Diese Art der Stromzufuhr kann vorteilhaft bei einem Substrat 3 aus einem nichtleitenden Material wie z.B. Glas, Quarz, Saphir oder Kunststoff eingesetzt werden.

Im Bereich des Vertikalemitters 1 ist auf den Bragg-Reflektor 4 die aktive Vertikalemitterzone 5 aufgebracht. Wie das im Zusammenhang mit Figur 1 beschriebene Ausführungsbeispiel enthält die Vertikalemitterzone 5 organische halbleitende Materialien, bevorzugt als Schichtenstapel mit alternierend gestapelten Schichten eines optisch aktiven und eines optisch inaktiven Materials. Auf die Vertikalemitterzone 5 ist eine Wellenleiterschicht 10 aufgebracht und auf diese ein interner Resonatorspiegel 11.

Im Unterschied zu Figur 1 sind in diesem Ausführungsbeispiel die Pumpstrahlungsschicht 8 und die Vertikalemitterzone 5 vertikal nacheinander angeordnet. Von der Pumpstrahlungsschicht 8 erzeugte Pumpstrahlung dringt beim Betrieb in die Wellenleiterschicht 10 ein, in der sie bei ihrer lateralen Ausbreitung auch in vertikaler Richtung propagiert. Bei geeigneter Auslegung der vertikalen Wellenleitereigenschaften der Wellenleiterschicht 10 kann auf diese Weise die aktive Vertikalemitterzone 5 lateral homogener gepumpt werden, als es bei direktem seitlichen Einstrahlen der Pumpstrahlung in die Vertikalemitterzone 5 möglich ist.

Der interne Resonatorspiegel 11 ermöglicht den Betrieb der Halbleiterlaservorrichtung auch ohne externen Resonatorspiegel. Aufgrund der kürzeren Resonatorlänge kann bei Einsatz des internen Resonatorspiegels 11 nur eine geringere Resonatorgüte erreicht werden als beim Einsatz eines externen Resonatorspiegels. Eine sich daraus unter Umständen ergebende größere Linienbreite der Vertikalstrahlung ist jedoch beispielsweise für Anzeigenzwecke unerheblich. Der interne Resonatorspiegel 11 kann analog zum Bragg-Reflektor 4 als dielektrischer Spiegelstapel ausgeführt sein. Besonders vorteilhaft ist, sowohl die Wellenleiterschicht 10 als auch den internen Resonatorspiegel 11 durch organische Schichten zu bilden. Ein Aufbringen von anorganischen Schichten auf organische Schichten, das aus thermischen Gründen nicht unproblematisch ist, kann so verzichtet werden.

In Figur 4 ist ein Ausschnitt einer Draufsicht auf ein viertes Ausführungsbeispiel einer Halbleiterlaservorrichtung gezeigt. Bei dieser Halbleiterlaservorrichtung ist auf einem in der Figur nicht sichtbaren Substrat eine Vielzahl von Vertikalemittern 1 in einem regelmäßigen rechteckigen Muster angeordnet. Im Unterschied zu der in Figur 2 gezeigten Halbleiterlaservorrichtung, die eine Vielzahl an stabförmigen Pumpstrahlungsquellen 2 aufweist, ist hier nur eine zusammenhängende Pumpstrahlungsquelle 2 vorgesehen.

Eine solche Anordnung kann vorteilhaft mit einer organischen Pumpstrahlungsquelle 2 realisiert werden, die großflächig beispielsweise durch Aufschleudern auf das Substrat aufgebracht wird. Die Kanten einer aktiven Schicht der Pumpstrahlungsquelle 2 werden nicht verspiegelt, sodass die Pumpstrahlungsquelle 2 kein Laser darstellt. Dennoch kann Aufgrund der großen Fläche innerhalb der aktiven Schicht der Pumpstrahlungsquelle 2 eine zum optischen Pumpen der Vertikalemitter 2 ausreichende Lichtintensität erzeugt werden.

## Patentansprüche

1. Halbleiterlaservorrichtung mit
- mindestens einem optisch gepumpten, oberflächenemittierenden Vertikalemitter (1) mit mindestens einer strahlungserzeugenden Vertikalemitterzone (5),
- mindestens einer monolithisch integrierten Pumpstrahlungsquelle (2) zum optischen Pumpen des Vertikalemitters (1), die zur Emission von Pumpstrahlung in einer Hauptstrahlungsrichtung eingerichtet ist, die quer zu einer Hauptstrahlungsrichtung einer Vertikalstrahlung des Vertikalemitters (1) verläuft,
**dadurch gekennzeichnet, dass**
die mindestens eine Vertikalemitterzone (5) des Vertikalemitters (1) mindestens eine Schicht aufweist, die strahlungserzeugendes organisches Material enthält.

2. Halbleiterlaservorrichtung nach Anspruch 1, **dadurch gekennzeichnet, dass**
das organische Material halbleitend ist.

3. Halbleiterlaservorrichtung nach einem der Ansprüche 1 oder 2, **dadurch gekennzeichnet, dass**
der Vertikalemitterzone (5) in vertikaler Richtung ein interner Resonatorspiegel nachgeordnet ist.

4. Halbleiterlaservorrichtung nach Anspruch 3, **dadurch gekennzeichnet, dass**
der interne Resonatorspiegel ein Bragg-Reflektor (4) ist.

5. Halbleiterlaservorrichtung nach einem der Ansprüche 3 oder 4, **dadurch gekennzeichnet, dass**
der interne Resonatorspiegel zwischen der mindestens einen Vertikalemitterzone (5) und einem Substrat (3) angeordnet ist und die Vertikalstrahlung auf der dem Substrat (3) gegenüberliegenden Seite ausgekoppelt wird.

6. Halbleiterlaservorrichtung nach einem der Ansprüche 3 oder 4, **dadurch gekennzeichnet, dass**
der interne Resonatorspiegel einem Substrat (3) und der mindestens einen Vertikalemitterzone (5) nachgeordnet ist und die Vertikalstrahlung durch das Substrat (3) ausgekoppelt wird.

7. Halbleiterlaservorrichtung nach Anspruch 6, **dadurch gekennzeichnet, dass**
im Substrat zur Auskopplung der von der mindestens einen Vertikalemitterzone (5) erzeugten Vertikalstrahlung ein Auskoppelfenster vorgesehen ist.

8. Halbleiterlaservorrichtung nach einem der Ansprüche 3 bis 7, **dadurch gekennzeichnet, dass**
der mindestens einen Vertikalemitterzone (5) ein externer Spiegel zugeordnet ist, der zusammen mit dem internen Resonatorspiegel einen Resonator für den Vertikalemitter (1) bildet.

9. Halbleiterlaservorrichtung nach einem der Ansprüche 3 bis 7, **dadurch gekennzeichnet, dass**
ein weiterer interner Resonatorspiegel (11) vorgesehen ist, wobei der weitere interne Resonatorspiegel (11) und der interne Resonatorspiegel die Vertikalemitterzone (5) in vertikaler Richtung umschließen und so einen Resonator für die Vertikalstrahlung bilden, und wobei der weitere interne Resonatorspiegel (11) teildurchlässig ist und der Auskopplung der Vertikalstrahlung dient.

10. Halbleiterlaservorrichtung nach einem der Ansprüche 1 bis 9, **dadurch gekennzeichnet, dass**
die mindestens eine Pumpstrahlungsquelle (2) ein kantenemittierender Laser ist.

11. Halbleiterlaservorrichtung nach einem der Ansprüche 1 bis 10, **dadurch gekennzeichnet, dass**
mindestens zwei Pumpstrahlungsquellen (2) auf einander gegenüberliegenden Seiten des mindestens einen Vertikalemitters (1) angeordnet sind, wobei die mindestens zwei Pumpstrahlungsquellen (2) einen gemeinsamen Resonator aufweisen und zusammen einen Laser bilden.

12. Halbleiterlaservorrichtung nach einem der Ansprüche 1 bis 11, **dadurch gekennzeichnet, dass**
die mindestens eine Pumpstrahlungsquelle eine aktive, strahlungserzeugende Pumpschicht (8) aufweist, die in vertikaler Richtung zumindest teilweise mit der aktiven Vertikalemitterzone (5) überlappend angeordnet ist.

13. Halbleiterlaservorrichtung nach einem der Ansprüche 1 bis 11, **dadurch gekennzeichnet, dass**
die mindestens eine Pumpstrahlungsquelle (2) eine aktive, strahlungserzeugende Pumpschicht (8) aufweist, die in vertikaler Richtung der aktiven Vertikalemitterzone (5) nachgeordnet ist.

14. Halbleiterlaservorrichtung nach einem der Ansprüche 1 bis 13, **dadurch gekennzeichnet, dass**
die mindestens eine Pumpstrahlungsquelle (2) eine Schichtenfolge auf Basis eines III-V oder eines II-VI Verbindungshalbleiters aufweist.

15. Halbleiterlaservorrichtung nach einem der Ansprüche 1 bis 14, **dadurch gekennzeichnet, dass**
die mindestens eine Pumpstrahlungsquelle (2) mindestens eine Schicht aufweist, die ein halbleitendes organisches Material enthält.

16. Halbleiterlaservorrichtung nach Anspruch 15, **dadurch gekennzeichnet, dass**
das organische Material der mindestens einen Schicht des Vertikalemitters (1) und/oder der Pumpstrahlungsquelle (2) ein Polymer ist oder
dass das organische Material der mindestens einen Schicht des Vertikalemitters (1) und/oder der Pumpstrahlungsquelle (2) niedermolekulare organische Verbindungen aufweist.

17. Halbleiterlaservorrichtung nach einem der Ansprüche 1 bis 16, **dadurch gekennzeichnet, dass**
die Wellenlänge der Pumpstrahlung kleiner ist als die Wellenlänge der Vertikalstrahlung.

18. Halbleiterlaservorrichtung nach einem der Ansprüche 1 bis 17, **dadurch gekennzeichnet, dass**
mindestens zwei Vertikalemitter (1) mit unterschiedlichen Wellenlängen ihrer Vertikalstrahlung vorgesehen sind.

19. Halbleiterlaservorrichtung nach einem der Ansprüche 1 bis 18, **dadurch gekennzeichnet, dass**
eine Mehrzahl von Vertikalemittern (1) in einer regelmäßigen Anordnung vorgesehen ist.

20. Halbleiterlaservorrichtung nach Anspruch 5 oder 6 und nach dem vorhergehenden Anspruch, **dadurch gekennzeichnet, dass**
auf dem Substrat (3) die Mehrzahl der Vertikalemitter (1) in einem regelmäßigen rechteckigen Muster angeordnet ist, und dass zwischen den Vertikalemittern (1) die Pumpstrahlungsquellen (2) vorgesehen sind.

21. Halbleiterlaservorrichtung nach dem vorhergehenden Anspruch, **dadurch gekennzeichnet, dass** jede der Pumpstrahlungsquellen (2) einen Laserresonator darstellt, der zum optischen Pumpen einer oder beider benachbarter Vertikalemitter (1) vorgesehen ist.

22. Halbleiterlaservorrichtung nach Anspruch 5 oder 6 und nach Anspruch 19, **dadurch gekennzeichnet, dass** auf dem Substrat (3) die Mehrzahl der Vertikalemitter (1) in einem regelmäßigen rechteckigen Muster angeordnet ist, und dass nur eine zusammenhängende Pumpstrahlungsquelle (2) vorgesehen ist.

23. Verfahren zur Herstellung einer Halbleiterlaservorrichtung nach einem der Ansprüche 1 bis 19, umfassend die Schritte:
- Bereitstellen eines Substrats (3),
- Aufbringen einer Halbleiterschichtenfolge auf das Substrat (3), wobei die Halbleiterschichtenfolge eine strahlungserzeugende Schicht aufweist und geeignet ist, eine Pumpstrahlungsquelle (2) zu bilden,
- Herstellen von mindestens einer Ausnehmung in der Halbleiterschichtenfolge,
- Aufbringen einer Schichtenfolge in die mindestens eine Ausnehmung in der Halbleiterschichtenfolge, wobei die Schichtenfolge mindestens eine strahlungserzeugende Schicht aufweist, die ein strahlungserzeugendes organisches Material enthält, und wobei die Schichtenfolge geeignet ist, einen Vertikalemitter (1) zu bilden.

24. Verfahren nach einem Anspruch 23, bei dem der Schritt des Herstellen der mindestens einen Ausnehmung einen Ätzschritt umfasst.

25. Verfahren nach einem der Ansprüche 23 oder 24, bei dem der Schritt des Herstellen der mindestens einen Ausnehmung durch eine Maskierung des Substrats (3) während des Aufbringens der Halbleiterschichtenfolge realisiert wird.

## Claims

1. Semiconductor laser device comprising
- at least one optically pumped surface emitting vertical emitter (1) having at least one radiation-generating vertical emitter zone (5),
- at least one monolithically integrated pump radiation source (2) for optically pumping the vertical emitter (1) and designed for emitting pump radiation in a main radiation direction running transversely with respect to a main radiation direction of a vertical radiation of the vertical emitter (1),
**characterized in that**
the at least one vertical emitter zone (5) of the vertical emitter (1) has at least one layer containing radiation-generating organic material.

2. Semiconductor laser device according to Claim 1, **characterized in that**
the organic material is semiconducting.

3. Semiconductor laser device according to either of Claims 1 and 2, **characterized in that**
an internal resonator mirror is disposed downstream of the vertical emitter zone (5) in a vertical direction.

4. Semiconductor laser device according to Claim 3, **characterized in that**
the internal resonator mirror is a Bragg reflector (4).

5. Semiconductor laser device according to either of Claims 3 and 4, **characterized in that**
the internal resonator mirror is arranged between the at least one vertical emitter zone (5) and a substrate (3) and the vertical radiation is coupled out on the opposite side to the substrate (3).

6. Semiconductor laser device according to either of Claims 3 and 4, **characterized in that**
the internal resonator mirror is disposed downstream of a substrate (3) and the at least one vertical emitter zone (5) and the vertical radiation is coupled out through the substrate (3).

7. Semiconductor laser device according to Claim 6, **characterized in that** a coupling-out window is provided in the substrate for coupling out the vertical radiation generated by the at least one vertical emitter zone (5).

8. Semiconductor laser device according to any of Claims 3 to 7, **characterized in that**
the at least one vertical emitter zone (5) is assigned an external mirror which, together with the internal resonator mirror, forms a resonator for the vertical emitter (1).

9. Semiconductor laser device according to any of Claims 3 to 7, **characterized in that** a further internal resonator mirror (11) is provided, wherein the further internal resonator mirror (11) and the internal resonator mirror enclose the vertical emitter zone (5) in a vertical direction and thus form a resonator for the vertical radiation, and wherein the further internal resonator mirror (11) is partly transmissive and serves for coupling out the vertical radiation.

10. Semiconductor laser device according to any of Claims 1 to 9, **characterized in that**
the at least one pump radiation source (2) is an edge emitting laser.

11. Semiconductor laser device according to any of Claims 1 to 10, **characterized in that** at least two pump radiation sources (2) are arranged on mutually opposite sides of the at least one vertical emitter (1), wherein the at least two pump radiation sources (2) have a common resonator and together form a laser.

12. Semiconductor laser device according to any of Claims 1 to 11, **characterized in that**
the at least one pump radiation source has an active, radiation-generating pump layer (8), which is arranged in a manner at least partly overlapping the active vertical emitter zone (5) in a vertical direction.

13. Semiconductor laser device according to any of Claims 1 to 11, **characterized in that**
the at least one pump radiation source (2) has an active, radiation-generating pump layer (8), which is disposed downstream of the active vertical emitter zone (5) in a vertical direction.

14. Semiconductor laser device according to any of Claims 1 to 13, **characterized in that**
the at least one pump radiation source (2) has a layer sequence based on a III-V or a II-VI compound semiconductor.

15. Semiconductor laser device according to any of Claims 1 to 14, **characterized in that**
the at least one pump radiation source (2) has at least one layer containing a semiconducting organic material.

16. Semiconductor laser device according to Claim 15, **characterized in that**
the organic material of the at least one layer of the vertical emitter (1) and/or of the pump radiation source (2) is a polymer or
**in that** the organic material of the at least one layer of the vertical emitter (1) and/or of the pump radiation source (2) comprises low molecular weight organic compounds.

17. Semiconductor laser device according to any of Claims 1 to 16, **characterized in that**
the wavelength of the pump radiation is less than the wavelength of the vertical radiation.

18. Semiconductor laser device according to any of Claims 1 to 17, **characterized in that**
at least two vertical emitters (1) having different wavelengths of their vertical radiation are provided.

19. Semiconductor laser device according to any of Claims 1 to 18, **characterized in that**
a plurality of vertical emitters (1) are provided in a regular arrangement.

20. Semiconductor laser device according to Claim 5 or 6 and according to the preceding claim, **characterized in that**
the plurality of vertical emitters (1) are arranged in a regular rectangular pattern on the substrate (3),
and **in that** the pump radiation sources (2) are provided between the vertical emitters (1).

21. Semiconductor laser device according to the preceding claim, **characterized in that**
each of the pump radiation sources (2) constitutes a laser resonator provided for optically pumping one or both adjacent vertical emitters (1).

22. Semiconductor laser device according to Claim 5 or 6 and according to Claim 19, **characterized in that** the plurality of vertical emitters (1) are arranged in a regular rectangular pattern on the substrate (3),
and **in that** only one continuous pump radiation source (2) is provided.

23. Method for producing a semiconductor laser device according to any of Claims 1 to 19, comprising the following steps:
- providing a substrate (3),
- applying a semiconductor layer sequence to the substrate (3), wherein the semiconductor layer sequence has a radiation-generating layer and is suitable for forming a pump radiation source (2),
- producing at least one cutout in the semiconductor layer sequence,
- applying a layer sequence into the at least one cutout in the semiconductor layer sequence, wherein the layer sequence has at least one radiation-generating layer containing a radiation-generating organic material, and wherein the layer sequence is suitable for forming a vertical emitter (1).

24. Method according to Claim 23, wherein
the step of producing the at least one cutout comprises an etching step.

25. Method according to either of Claims 23 and 24, wherein
the step of producing the at least one cutout is realized by masking the substrate (3) during the process of applying the semiconductor layer sequence.

## Revendications

1. Dispositif laser à semi-conducteur qui présente :
- au moins un émetteur vertical (1) à émission de surface, pompé optiquement et doté d'au moins une zone (5) d'émission verticale émettant un rayonnement,
- au moins une source (2) de rayonnement pompé intégrée monolithiquement, qui pompe optiquement l'émetteur vertical (1) et qui est conçue pour émettre le rayonnement pompé dans une direction principale d'émission qui s'étend transversalement à la direction d'émission principale du rayonnement vertical de l'émetteur vertical (1),
**caractérisé en ce que**
la ou les zones verticales d'émission (5) de l'émetteur vertical (1) présentent au moins une couche qui contient un matériau organique qui émet un rayonnement.

2. Dispositif laser à semi-conducteur selon la revendication 1, **caractérisé en ce que** le matériau organique est semi-conducteur.

3. Dispositif laser à semi-conducteur selon l'une des revendications 1 ou 2, **caractérisé en ce que** la zone (5) d'émission verticale est située en aval d'un miroir résonateur interne dans la direction verticale.

4. Dispositif laser à semi-conducteur selon la revendication 3, **caractérisé en ce que** le miroir résonateur interne est un réflecteur de Bragg (4).

5. Dispositif laser à semi-conducteur selon l'une des revendications 3 ou 4, **caractérisé en ce que** le miroir résonateur interne est disposé entre la ou les zones d'émission verticale (5) et un substrat (3) et **en ce que** le rayonnement vertical est découplé sur le côté situé face au substrat (3).

6. Dispositif laser à semi-conducteur selon l'une des revendications 3 ou 4, **caractérisé en ce que** le miroir résonateur interne est disposé en aval d'un substrat (3) et de la ou des zones d'émission verticale (5) et **en ce que** le rayonnement vertical est découplé par le substrat (3).

7. Dispositif laser à semi-conducteur selon la revendication 6, **caractérisé en ce qu'**une fenêtre de découplage est prévue dans le substrat pour découpler le rayonnement vertical émis par la ou les zones d'émission verticale (5).

8. Dispositif laser à semi-conducteur selon l'une des revendications 3 à 7, **caractérisé en ce qu'**un miroir externe est associé à la ou aux zones d'émission verticale (5) et forme avec le miroir résonateur interne un résonateur pour l'émetteur vertical (1).

9. Dispositif laser à semi-conducteur selon l'une des revendications 3 à 7, **caractérisé en ce qu'**il présente un autre miroir résonateur interne (11), l'autre miroir résonateur interne (11) et le miroir résonateur interne entourant la zone d'émission verticale (5) dans la direction verticale et formant ainsi un résonateur pour le rayonnement vertical, l'autre miroir résonateur interne (11) étant partiellement transparent et servant à découpler le rayonnement vertical.

10. Dispositif laser à semi-conducteur selon l'une des revendications 1 à 9, **caractérisé en ce que** la ou les sources (2) de rayonnement pompé sont un laser émettant par les bords.

11. Dispositif laser à semi-conducteur selon l'une des revendications 1 à 10, **caractérisé en ce qu'**au moins deux sources (2) de rayonnement pompé sont disposées sur des côtés mutuellement opposés du ou des émetteurs verticaux (1), les deux ou plusieurs sources (2) de rayonnement pompé présentant un résonateur commun et formant ensemble un laser.

12. Dispositif laser à semi-conducteur selon l'une des revendications 1 à 11, **caractérisé en ce que** la ou les sources de rayonnement pompé présentent une couche active de pompage (8) émettant un rayonnement disposée dans la direction verticale en superposée au moins en partie à la zone active d'émission verticale (5).

13. Dispositif laser à semi-conducteur selon l'une des revendications 1 à 11, **caractérisé en ce que** la ou les sources (2) de rayonnement pompé présentent une couche active de pompage (8) émettant un rayonnement disposée en aval de la zone active d'émission verticale (5) dans la direction verticale.

14. Dispositif laser à semi-conducteur selon l'une des revendications 1 à 13, **caractérisé en ce que** la ou les sources (2) de rayonnement pompé présentent une succession de couches basée sur un semi-conducteur de liaison III-V ou II-VI.

15. Dispositif laser à semi-conducteur selon l'une des revendications 1 à 14, **caractérisé en ce que** la ou les sources (2) de rayonnement pompé présentent au moins une couche qui contient un matériau organique semi-conducteur.

16. Dispositif laser à semi-conducteur selon la revendication 15, **caractérisé en ce que** le matériau organique de la ou des couches de l'émetteur vertical (1) ou de la source (2) de rayonnement pompé est un polymère ou **en ce que** le matériau organique de la ou des couches de l'émetteur vertical (1) et/ou de la source (2) de rayonnement pompé présente des composés organiques à bas poids moléculaire.

17. Dispositif laser à semi-conducteur selon l'une des revendications 1 à 16, **caractérisé en ce que** la longueur d'onde du rayonnement pompé est inférieure à la longueur d'onde du rayonnement vertical.

18. Dispositif laser à semi-conducteur selon l'une des revendications 1 à 17, **caractérisé en ce qu'**il présente au moins deux émetteurs verticaux (1) dont les rayonnements verticaux ont des longueurs d'onde différentes.

19. Dispositif laser à semi-conducteur selon l'une des revendications 1 à 18, **caractérisé en ce que** plusieurs émetteurs verticaux (1) sont prévus en agencement régulier.

20. Dispositif laser à semi-conducteur selon les revendications 5 ou 6 ou selon la revendication précédente, **caractérisé en ce que** les différents émetteurs verticaux (1) sont disposés sur le substrat (3) suivant un motif rectangulaire régulier et **en ce que** les sources (2) de rayonnement pompé sont prévues entre les émetteurs verticaux (1).

21. Dispositif laser à semi-conducteur selon la revendication précédente, **caractérisé en ce que** chacune des sources (2) de rayonnement pompé constitue un résonateur laser prévu pour pomper optiquement un émetteur vertical (1) ou les deux émetteurs verticaux (1) voisins.

22. Dispositif laser à semi-conducteur selon les revendications 5 ou 6 ou selon la revendication 19, **caractérisé en ce que** les différents émetteurs verticaux (1) sont disposés sur le substrat (3) selon un motif rectangulaire régulier et **en ce que** seule une source continue (2) de rayonnement pompé est prévue.

23. Procédé de fabrication d'un dispositif laser à semi-conducteur selon l'une des revendications 1 à 19, le procédé comprenant les étapes qui consistent à :
- préparer un substrat (3),
- appliquer une succession de couches semi-conductrices sur le substrat (3), la succession de couches semi-conductrices présentant une couche qui émet un rayonnement et permettant de former une source (2) de rayonnement pompé,
- réalisation d'au moins une découpe dans la succession de couches semi-conductrices,
- application d'une succession de couches dans la ou les découpes ménagées dans la succession de couches semi-conductrices, la succession de couches présentant au moins une couche émettant un rayonnement qui contient un matériau organique émettant un rayonnement, la succession de couches permettant de former un émetteur vertical (1).

24. Procédé selon la revendication 23, dans lequel l'étape de réalisation de la ou des découpes comprend une étape de gravure.

25. Procédé selon l'une des revendications 23 ou 24, dans lequel l'étape de réalisation d'une ou plusieurs découpes est réalisée par masquage du substrat (3) pendant l'application de la succession de couches semi-conductrices.
